# EUROPEAN PATENT APPLICATION

(11) **EP 4 485 509 A1**
(43) Date of publication of application: **01.01.2025**
(21) Application number: 23217762.6
(22) Date of filing: 18.12.2023
(51) Int. Cl.: H01L 21/48, H01L 21/285, H01L 21/768, H01L 23/498, H01L 23/00, H01L 23/13

(54) **SEMICONDUCTOR LAYER WITH DRY DEPOSITION LAYER**

(30) Priority: 30.06.2023 US 202318217123
(71) Applicant: INTEL Corporation, Santa Clara, CA 95054 (US)
(72) Inventor: WALL, Marcel, Phoenix, 85048 (US); AZIMI, Hamid, Paradise Valley, 85253 (US); MANEPALLI, Rahul N., Chandler, 85249 (US); PIETAMBARAM, Srinivas V., Chandler, 85249 (US); GRUJICIC, Darko, Chandler, 85249 (US); CHO, Steve, Chandler, 85226 (US); SOUNART, Thomas L., Chandler, 85226 (US); DUAN, Gang, Chandler, 85248 (US); HAN, Jung Kyu, Chandler, 85226 (US); NAD, Suddhasattwa, Chandler, 85249 (US); DUONG, Benjamin, Phoenix, 85044 (US); KAVIANI, Shayan, Phoenix, 85048 (US)
(74) Representative: 2SPL Patentanwälte PartG mbB

(57) **Abstract**

An intermediary layer, such as a dry deposition layer or a surface finish, is deposited on at least one exposed surface of surfaces within a layer of a semiconductor substrate. The intermediary layer is deposited on at least an electrically conductive material within a cavity in a layer. The intermediary layer is deposited using a chemical deposition process such as physical vapor deposition, chemical vapor deposition or sputtering.

## Description

### TECHNICAL FIELD

This document pertains generally, but not by way of limitation, to electrical devices with layers and electrical connection points having exposed areas with an intermediary layer, such as a dry deposition layer or a surface finish, or the like, applied to specified surfaces for use with computer chips, chiplets, or similar electronic components.

### BACKGROUND

Computer chips, and other similar components (e.g., printed circuit boards) for electronic systems are formed from layers of materials that are usually stacked or placed one on top of the other. Computer chips, and other similar components, have, for example, layers or features that provide electrical connection points or electrical transmission passageways. Electrical connection points, electrical transmission passageways, or specified surfaces on a layer or computer chip at times benefits from a blocking layer deposited on an exposed surface. In an example, the layer, computer chip or PCB have an intermediary layer, such as a surface finish, deposited on at least a portion of an exposed surface.

In an example, a surface finish deposited and coupled (e.g., adhered, bonded, connected or the like) assists in increasing resistance to wear or corrosion to the associated substrate. In another example, a deposition of surface finish assists in improving the performance, integrity and lifespan of electrical components.

In an example, during manufacturing of a layer, chip, or printed circuit board (PCB), an intermediary layer, such as a surface finish, is an intermetallic joint between a solderable area of a chip and components coupled to the layer, chip or PCB. The surface finish, as the intermediary layer, in other examples, is a protective coating to minimize oxidation or similar reactions between a base metal and the environment. For example, the surface finish can assist in minimizing chemical reactions between a specified portion the surface of a layer, or component of a layer, and additional metals deposited proximate to the specified portion.

The complexity of computer chips, including layers and components, increases the complexity in manufacturing flows. Further, the complexity of computer chips, including layers and components, increases the need for precision in manufacturing and also increases the need for processes that minimize faults. For example, bubbles, gaps, or other undesired applications of surface finish can have unwanted consequences in manufacturing computer chips. In some examples, an undesired application of a surface finish results in an unusable chip.

In an example of a process to minimize flaws or defects, the surface finish, is applied in an electroless (e-less) surface finishing tool. For example, the layer or computer chip is placed and loosely retained in a basket in a specified orientation. The basket is then dropped, rocked or otherwise agitated to release the presence of bubbles and to form level surfaces of surface finish on the layer or computer chip. When the basket is dropped, rocked or otherwise agitated, the layer or chip can contact the sides of the basket. In some instances, the contact between the basket and the layer or chip damages the layer or computer chip.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
Figure 1 is an illustration of a cross section of an example layer of an electronic system.
Figure 2A is an illustration of a cross section of an example layer with an intermediary layer.
Figure 2B is an illustration of a cross section of an example layer with an intermediary layer.
Figure 3 is an illustration of a cross section of an example of a prior art layer.
Figure 4 is an illustration of a cross section of an example layer and a process of deposition.
Figure 5 is an illustration of a cross section of an example layer and a process of deposition.
Figure 6 is an illustration of a cross section of an example layer and a process of deposition.
Figure 7A is an illustration of at least one example layer stack including a plurality of layers.
Figure 7B is an illustration of at least one example layer including an electronic component.
Figure 8 is an illustration of a system level diagram, depicting an example of an electronic system.

### DETAILED DESCRIPTION

Layers of materials, for example resins, polymers, glass or the like, form the structure, foundation or architecture for substrates that form computer chips. For example, an individual layer can be made from polymer, polymer resin, glass, or any material suitable for the purpose. Optionally, adjacent, subsequent of additional layers include different materials. The foundation, or base, of the layers can be a core layer coupled to other layers made from the same or similar materials and can include other components (e.g., electrical, structural, or the like).

In an example, the layer has electrical components coupled, formed, manufactured, or the like onto or into the layer. Some layers can include one or more electrical components such as an electrically conductive surface, resistors, capacitors, solder bumps, or the like. In an example, the one or more electrical component benefits from a protective coating, film or layer deposited, placed, adhered or the like covering the one or more electrical component. For example, an intermediary layer, such as a surface finish, protects surfaces or areas of a layer or components coupled to a layer. In an example, the intermediary layer is a layer deposited, placed, adhered or the like on specified surfaces as a layer between an electrical component and a structure, such as a core layer, or subsequent layer in an electronic system, such as a semiconductor substrate. In another example, the intermediary layer is a layer deposited, placed, adhered, or the like on specified surfaces which protects the specified surface from the environment. Intermediary layers, such as surface finishes, are known to protect, for example, electrical components and can increase the lifespan of the electrical components. In another example, the surface finish also protects the electrical components from environmental conditions, damage or the like during use or during manufacturing. In an example, surface finish deposited over at least the electrical component and sometimes the surrounding surfaces to protect the electrical components.

Deposition of the intermediary layer, such as deposition of a surface finish, in some examples, is either an electrolytic (e-lytic) plating or an electroless (e-less) plating. In electrolytic plating, the surfaces of the layer are first cleaned. The layer is then submerged in a bath of electrolyte solution along with a deposit of metal used for plating. For e-lytic plating, the layer and bath are subjected to electricity to cause the metal to bind and be deposited on the surfaces. An example of an e-less is similar to e-lytic plating. However, in e-less plating electricity is not used; instead, a chemical reaction occurs between the selected metal and the surface submerged in the bath.

In an example of applying an e-less or e-lytic surface finish to a layer, a layer is placed in a basket of a finishing tool. During the reaction between the metal and the layer, hydrogen can be generated. The hydrogen, in some examples, forms bubbles on the surface of the layer. The hydrogen bubbles can block areas on the surface of the layer from receiving an appropriate layer of plating. In an example, the hydrogen bubbles need to be removed.

A "rock and shock" process can be used to remove bubbles, such as hydrogen bubbles. During "rock and shock", the layer, for example, is held in a container, such as a basket, and subjected to vibrations. In an example, container is moved up and down to "shock" the object to release bubbles. For example, the container is moved up and down around 0.5 cm to around 1.0 cm. In an example, the container is moved, or rocked, side to side. For example, the container is moved side to side around 0.5 cm to around 1.0 cm. In some examples, the object is not securely held or retained. For example, during the process the item intentionally or unintentionally contacts the sides of the container or basket.

In some examples, a metal container holds the object, such as the layer. One observed fault to "rock and shock" includes damage to the object. For example, during movement of the basket a loosely retained object contacts the sides of the basket. In an example, the object is a layer or a substrate for a computer chip. In some examples, the layer is glass.

In an example with a glass layer, a deposition of e-less surface finish is applied to the layer. In an example, removal of any hydrogen bubbles occurs by subjecting the layer to rock and shock. In some examples, the layer can be damaged from movement of the layer within the container. The present inventors have recognized eliminating or minimizing the need for a separate mechanical action, such as rock and shock, to the layer can minimize damage to the final product, such as a semiconductor substrate, PCB or the like.

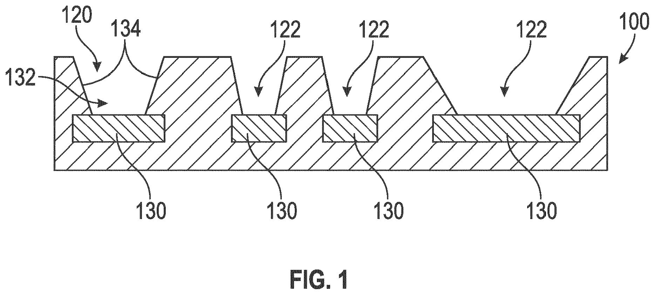

Figure 1 illustrates an example of a layer 100 with at least one opening 120. The layer 100 can be formed from any material designated for the purpose. For example, the layer 100 can be a solder resist applied to a substrate. In another example, the layer 100 can be a dielectric material. In yet another example, the layer 100 can be formed from a polymer or glass material. The layer 100 can be connected, coupled, adhered or the like to subsequent layers, such as to form a package, substrate, PCB or the like. In other examples, components for an electrical system, are coupled to the layer.

In an example, the layer 100 is electrically connected to subsequent layers via pathways such as at least one through hole extending from an at least one opening 120 in a surface of the layer 100. In an example, lithography designates the location of the at least one opening 120. A drill, laser or the like carves out (e.g., removes material in the layer) thereby forming the through hole or at least one opening 120.

In the example illustrated in Figure 1, the layer 100 includes at least one opening 120 providing electrical connections pathways between adjacent layers or between two different areas of a layer. In another example, the at least one opening 120 extends only partially into the layer 100. In an example, the layer 100 is a solder resist and the at least one opening 120 is a solder resist opening (SRO). In another example the layer 100 is a dielectric material with at least one opening 120. In another example, the layer 100 is a layer of glass with at least one opening 120.

In one example, a cavity 122 extends from the at least one opening 120 and into the layer 100. For example, the cavity 122 extending from the at least one opening 120 is a foundation, support or location for coupling (e.g., attached, affixed, bonded or the like) components to the layer 100. For example, the cavity 122 extending from a corresponding at least one opening 120 is for a fiducial. In another example, the at least one opening 120 includes a cavity 122 for supporting a first layer interconnect (FLI) bump. In a further example, the at least one opening 120 includes a cavity 122 that supports a capacitor pad, such as a die side capacitor (DSC) pad or a land-side capacitor (LSC) pad. In yet another example, the at least one opening 120 has a cavity 122 that supports a resistor, transformer, inductors or other electrical components. Optionally, the layer 100 includes at least one opening 120 with a cavity 122 for supporting a combination of fiducials, electrical components or FLI bumps.

In an example, the cavity includes an electrically conductive material 130. For example, the electrically conductive material 130 is embedded within the layer. In another example, the electrically conductive material 130 is disposed within the cavity proximate to a base 132 of the cavity 122. In another example, at least one surface 134 of the cavity 122 has a deposit of electrically conductive material 130 adhered to it.

Optionally, the electrically conductive material 130 is a copper plate. In an example, the copper plate 130 is disposed, positioned, placed, deposited or the like on proximate to the base 132. In an example, the electrically conductive material 130 assists transmitting electrical signals throughout the layer, substrate, chip, PCB or the like. In another example, the electrically conductive material 130 deposited in the cavity 122 assists in transmitting electrical signals between components coupled to the layer 100.

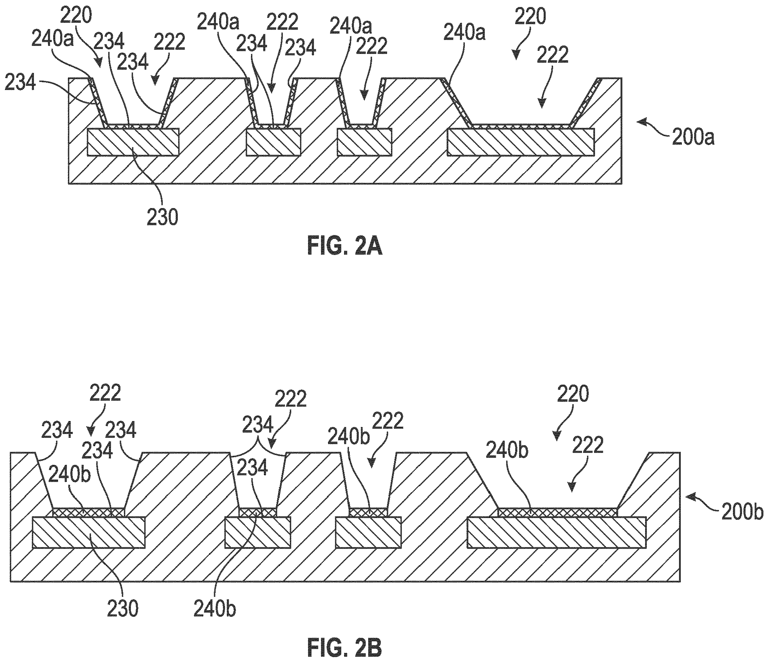

As illustrated in the examples of Figures 2A and 2B, an intermediary layer, such as a layer formed by dry deposition (e.g., a dry deposition layer), 240a, 240b covers at least a portion of exposed surfaces of the layer 100. In an example, the intermediary layer 240a, 240b is a film or thin layer of a specified metal. For example, the intermediary layer 240a, 240b is a dry deposition layer that is a surface finish formed from at least one of nickel, palladium and gold. The metal used for such a surface finish or dry deposition layer can also be an alloy of one or nickel, palladium and gold. The intermediary layer 240a, 240b can also be formed from other metals, such as aluminum or titanium, or any other metal or metal alloy suitable for the desired purpose.

As illustrated in Figure 2A, the intermediary layer 240a is coupled to at least a portion of the exposed surfaces 234. For example, the intermediary layer 240a is coupled to the exposed surfaces 234 within the at least one cavity 222. The exposed surfaces 234 within the cavity 222 can include the exposed surfaces 234 of the layer 200a and the exposed surface 234 of the electrically conductive material 230. In the example illustrated in Figure 2B, the intermediary layer 240b can be coupled to at least one exposed surface 234 within the at least one cavity 222. For example, the intermediary layer 240b is deposited on the exposed surface 234 of the electrically conductive material 230.

In an example, the intermediary layer 240a, 240b is dry deposition layer that includes a passivation layer applied to the exposed surface 234 of the electrically conductive material 230. A passivation layer can act as shielding material applied to the exposed surfaces 234 within the cavity 222. For example, the material forming the passivation layer includes a metal that coats the electrically conductive material 230 so the exposed surface 234 of the electrically conductive material 230 becomes less readily affected or corroded by environmental conditions.

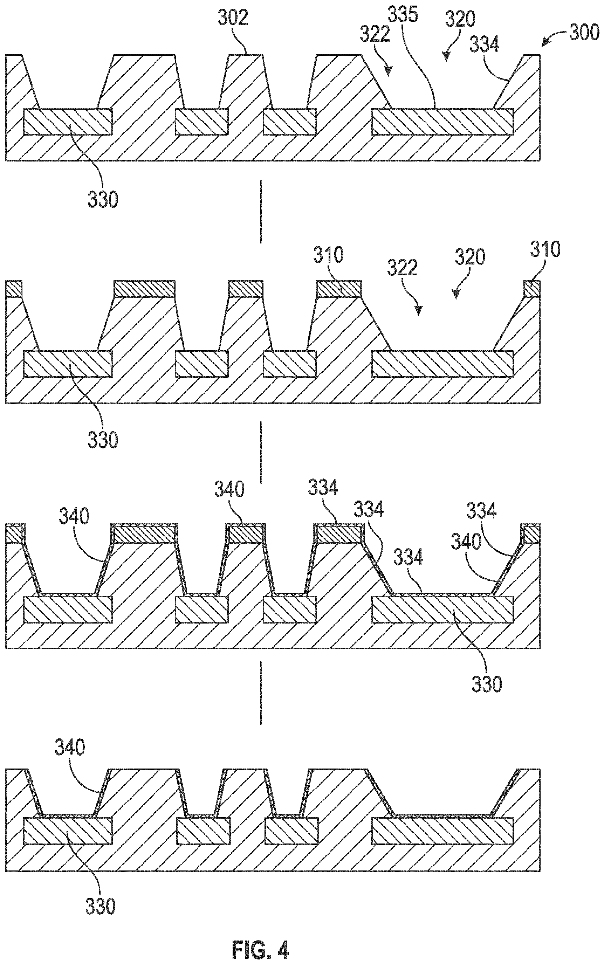

As illustrated in Figure 4, an intermediary layer, such as a dry deposition layer 340 is a layer (e.g., film, thin layer, or the like) of at least one metal that is deposited (applied, coupled, or the like) to a surface on or within a layer 300. In an example, the dry deposition layer 340 is a layer (e.g., film, thin layer or the like) of at least one of nickel, palladium or gold. Optionally, the dry deposition layer 340 is a surface finish. In an example, the dry deposition layer 340 is applied within or on a layer using a specified technique. In an example, the dry deposition layer uses a process that is not liquid based (e.g., immersing the layer, wafter, or the like in a liquid). For example, one technique includes depositing the dry deposition layer with sputtering or physical vapor deposition (PVD). In another example, one technique includes depositing the dry deposition layer with chemical vapor deposition (CVD) or atomic layer deposition (ALD). For example, exposing the layer to a gaseous process without a liquid component. In the example using CVD or ALD, the dry deposition layer is deposited primarily on copper pads or layers and a blocking layer is formed on the surfaces and areas where the dry deposition layer is not needed.

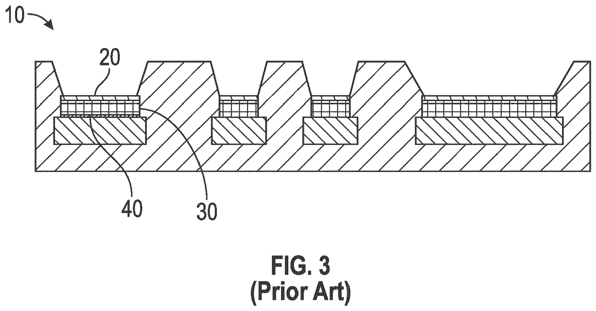

In an example, the dry deposition layer can be detected by its difference from deposition layers applied with, for example, an e-less or an e-lytic process. Illustrated in Figure 3 is an example of a layer 10 with a deposition layer 20 formed with an e-less or e-lytic process. In this example, the deposition layer 20 is detectable because of a soft etch that is detectable through an undercut 30. Whereas, in the examples illustrated in Figures 2A and 2B, there is minimal, if any, undercut in the layer 200a, 200b.

In another example, the dry deposition layer can be detected because of the lack of a seed layer. For example, when the layer 10, as illustrated in Figure 3, is viewed or observed using a scanning electron microscope (SEM) or energy dispersive spectroscopy (EDS), a seed layer such as a copper seed layer 40 is detectable. However, in a layer with a dry deposition layer applied, a seed layer is not applied and therefore not present or detectable.

In the example layer illustrated in Figure 4, a dry deposition layer 340 is applied to at least one exposed surface 334 of the layer 300. For example, the dry deposition layer 340 is applied to at least one of the exposed surface 334 of the blocking layer 310 (e.g., a photoresist), the exposed surface 334 of the cavity 322, and the exposed surface 334 of the electrically conductive material 330. In one instance, the dry deposition layer 340 is applied to all of the exposed surfaces 334 of the layer 300.

Illustrated in Figure 4 is one example of a method for applying an intermediary layer, such as a dry deposition layer 340, to a layer 300 of, for example, as semiconductor substrate. In an example, the layer is a layer of a semiconductor substrate layer. In one example, the layer 300 is a solder resist. In another example, the layer 300 is a dielectric material. In yet another example, the layer 300 is a glass layer.

The layer 300 can have lithographic process applied to a surface. In this example, lamination applies a blocking layer 310 (e.g., a protective layer such as a photoresist) to a first surface 302 of the layer 300. The blocking layer 310 is an example of a material used for protection of a first surface 302 or for prohibiting other materials from adhering to the first surface 302. In an example, lithography defines locations of at least one opening 320 in a first surface 302. For example, the material removed from within the layer 300 corresponds to the at least one opening 320. The material within the layer 300 can be removed by laser, carving, or the like. Each cavity formed from the removal of material corresponds to at least one opening 320. Each cavity of the plurality of cavities 322 can extend through (e.g., a through hole or through via), or partially into, the layer 300.

The dry deposition layer 340 can be applied with a sputtering deposition method such as physical vapor deposition (PVD). In an example, sputtering deposition is a method of ejecting a material, such as a metal in molecular form, from a target toward the layer 300. Sputtering deposition can cover the layer 300 with a metal emitted from the target. For example, a gold-palladium alloy can be sputtered from the target and deposited on the exposed surfaces of the layer 300. In another example, at least one of gold, palladium or nickel is deposited via sputtering on at least one exposed surface 334 of the layer. In one example, sputtering deposits all three of gold, palladium or nickel on at least one surface 334 of the layer 300. In another example, a deposition of any material suitable for the designated purpose of the layer 300 can applied.

After the application of the dry deposition layer 340, the blocking layer 310 (e.g., photoresist) can be removed from the first surface 302 of the layer 300. For example, planarization, etching, plasma etching, stripping or the like are methods of removing the blocking layer 310. In an example, the blocking layer 310 is a photoresist removed by etching.

When the blocking layer 310 has been removed, the layer 300 and the dry deposition layer 340 remain within the plurality of cavities 322. The dry deposition layer 340 and the layer can be cleaned, polished or the like. In the example method illustrated in Figure 3, the layer 300 formed from this process includes, at least the electrically conductive material 330 with the dry deposition layer 340 at least partially covering the exposed surface 334 of the electrically conductive material and also at least partially covering the exposed surfaces 334 within the cavity 322.

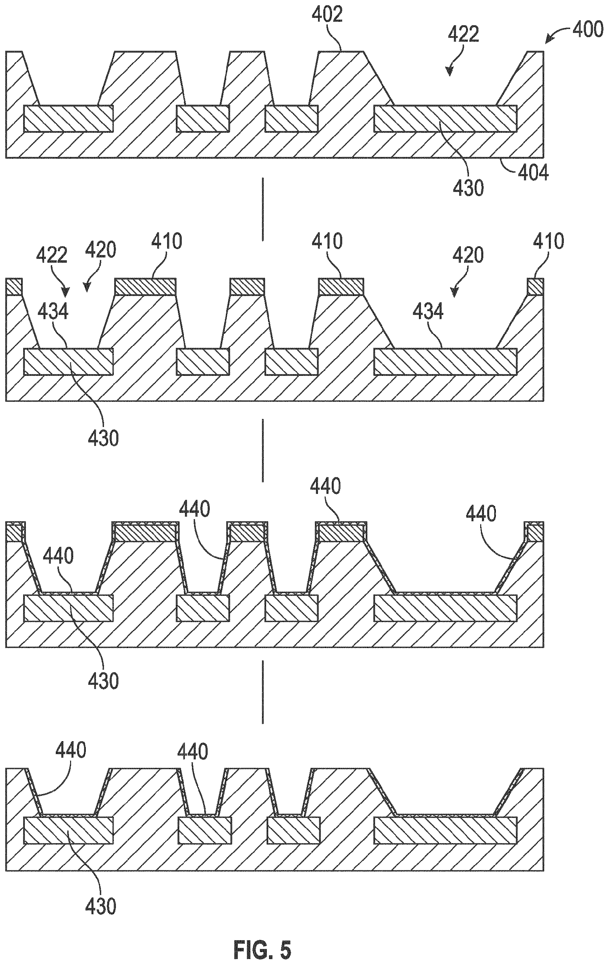

In the example method illustrated in Figure 5, a layer 400 is a component of a semiconductor substrate (e.g., semiconductor substrate layer). The layer 400 can be similar to the layer 300. Optionally, the example layer 400, a blocking layer 410 (e.g., protective layer such as a photoresist) is laminated, placed, adhered or the like, on at least one of a first surface 402 or a second surface 404.

In an example, at least one opening 420 is defined by lithographic printing on the blocking layer 410. At least one cavity 422 is formed to extend into the layer 400. In an example, the at least one cavity 422 extends partially into the layer 400. In another example, the at least one cavity 422 extends through the layer 400 and is a through hole extending from the first surface 402 to the second surface 404. In the example method illustrated in Figure 4, the at least one cavity 422 extends partially into the layer 400. The at least one cavity 422 exposes the electrically conductive material 430. In an example, the cavity 422 exposes an exposed surface 434 of the electrically conductive material 430.

In an example, an intermediary layer 440 is chemically applied to at least the exposed surface 434 of the electrically conductive material 430. In an example, at least one of chemical vapor deposition (CVD) or atomic layer deposition (ALD) applies or deposits the intermediary layer 440 to the layer 400. CVD is a method of chemically forming a thin layer or film on a surface of a layer. With CVD, a vacuum deposition method deposits a specified material in a thin layer on specified surfaces of a layer. Atomic layer deposition is a subclass of CVD. Atomic layer deposition is a method of forming a thin layer, film or the like uses chemical reactions to interact with the exposed surfaces of a layer to form a thin film.

In the example method illustrated in Figure 5, the selected materials of the intermediary layer, such as a dry deposition layer or surface finish, 440 interacts with at least the exposed surface 434 of the electrically conductive material 430. In another example, the selected material for the intermediary layer 440 interacts with both the exposed surfaces 434 within the cavity 422 and the exposed surface 434 of the electrically conductive material 430. In an example, the intermediary layer 440 is a surface finish. An example surface finish includes metals such as at least one of nickel, palladium or gold.

In the example method illustrated in Figure 5, the blocking layer 410 (e.g., photoresist) is removed. For example, the blocking layer 410 is a photoresist removed from the first surface 402 of the layer 400 while the intermediary layer, such as a surface finish, 440 remains within the at least one cavity 422. In one example, the intermediary layer 440 (e.g., dry deposition layer, surface finish or the like) remains deposited (e.g., adhered, coupled or the like) to the exposed surface 434 of a copper layer (e.g., plate, pad or the like) as the electrically conductive material 430. In another example, the intermediary layer 440 (e.g., dry deposition layer, surface finish or the like) remains deposited (e.g., adhered, coupled or the like) to each of the exposed surfaces 434 of the at least one cavity 422 and the copper layer.

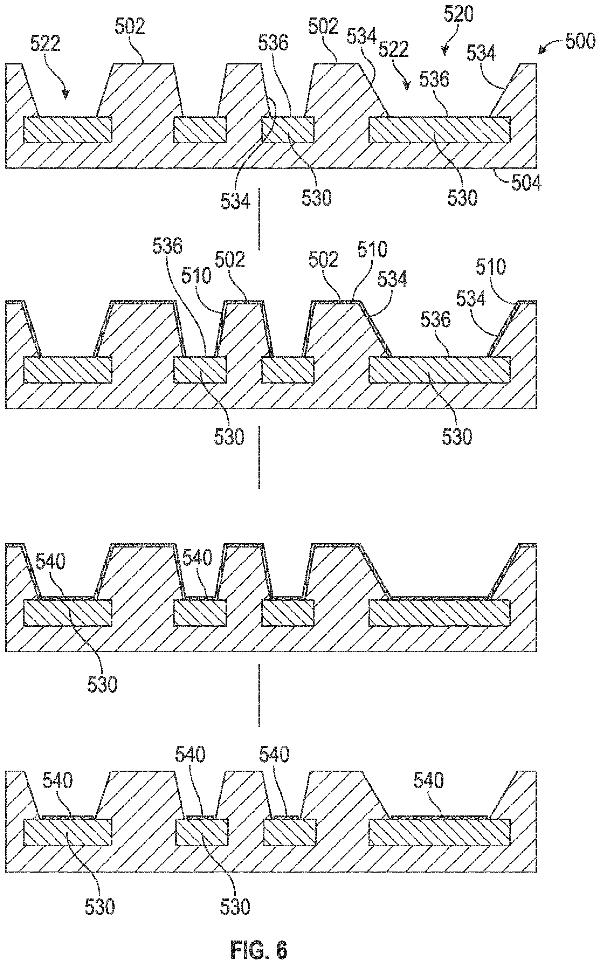

In the example illustrated in Figure 6, the layer 500 is a layer similar to layers 300, 400 discussed related to Figures 3 and 4. In an example method of forming a semiconductor substrate layer, the layer 500 includes an electrically conductive material 530 within at least one cavity 522 where the cavity 530 extends from at least one opening 520 into the layer 500. For example, an exposed surface 536 of the electrically conductive material 530 is exposed towards an opening 520 of the cavity 522. In an example, the electrically conductive material 530 is a copper plate (e.g., layer, pad, or the like) having an exposed surface 536.

In an example, a blocking layer 510 is deposited at least on the exposed surfaces 534 within the at least one cavity 522. For example, the blocking layer 510 is an ammonia-based material. An example of applying an ammonia-based blocking layer 510 includes selectively depositing the ammonia-based blocking layer 510 with at least one of CVD or ALD. For example, when the layer 500 is in a CVD chamber, the ammonia-based blocking layer flows through and preferentially deposits on the specified surfaces of the layer 500. In an example, the blocking layer 510 is applied concurrently with an intermediary layer 540 (e.g., dry deposition layer, surface finish or the like). In an example, the ammonia-based blocking layer 510 is applied to at least the exposed surfaces 534 within the at least one cavity 522 and to the first surface 502 of the layer 500. The ammonia-based blocking layer 510, for example, does not contact, or minimally contacts the electrically conductive material 530. In this example, the ammonia-based blocking layer 510 minimizes or prevents the intermediary layer 540 (e.g., dry deposition layer, surface finish or the like) from being deposited (e.g., adhered, coupled, or the like) on the exposed surfaces 534 of the at least one cavity 522.

In the example method illustrated in Figure 5, the intermediary layer 540 is deposited on the exposed surface 536 of the electrically conductive material 530. The intermediary layer, such as a dry deposition layer 540 is, for example, at least one of nickel, palladium or gold. In one example, the intermediary layer 540 is chemically deposited on the exposed surface 536 using at least one of physical vapor deposition (PVD), CVD or ALD. For example, the intermediary layer 540 (e.g., dry deposition layer, surface finish or the like) is deposited on the exposed surface 536 of the electrically conductive material 530 subsequent to deposition of the ammonia-based blocking layer 510.

The ammonia-based blocking layer 510, in an example, is removed after the dry deposition material is deposited (e.g., adhered, coupled or the like) to the exposed surface 536 of the electrically conductive material 530. In an example, the blocking layer 510 is removed using etching or a surface treatment.

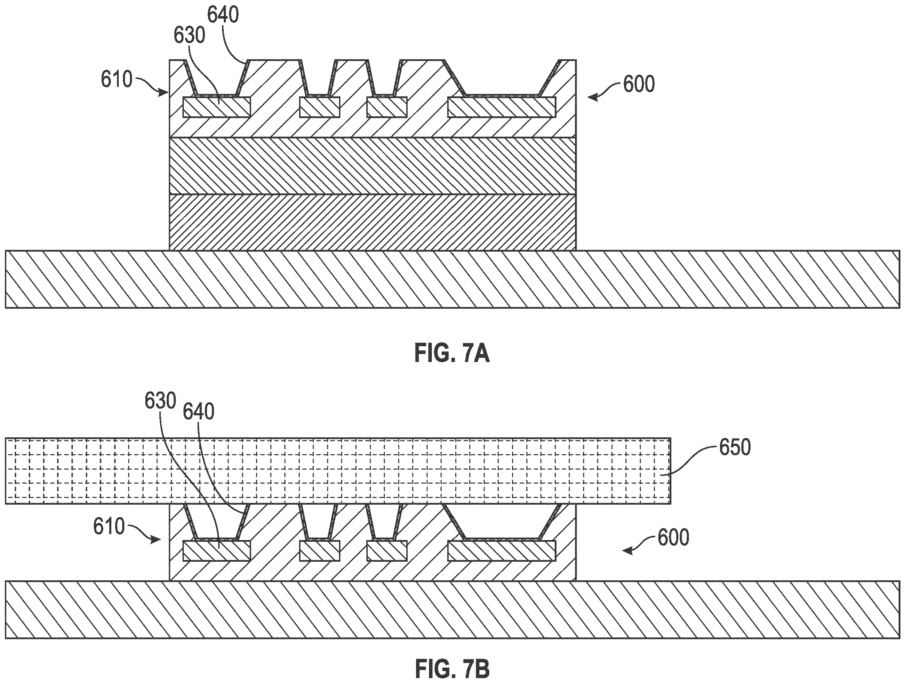

As illustrated in Figure 7A, each of the layers 300, 400, 500 as discussed in relation to the method Figures 3, 4 or 5, can be one layer of a plurality of layers 600. The plurality of layers 600, for example, can be components of a semiconductor, PCB or the like. For example, the layer 610 includes a cavity 622 with an electrically conductive metal 630 and an intermediary layer 640 (e.g., dry deposition layer, surface finish or the like).

As illustrated in Figure 7B, each of the layers 300, 400, 500 or the plurality of layers 600 can include a die 650 coupled to the layer 300, 400, 500, 600. In an example, the layer 600 can be a component of a system. For example, the layer 610 includes a cavity 622 with an electrically conductive metal 630 and an intermediary layer 640.

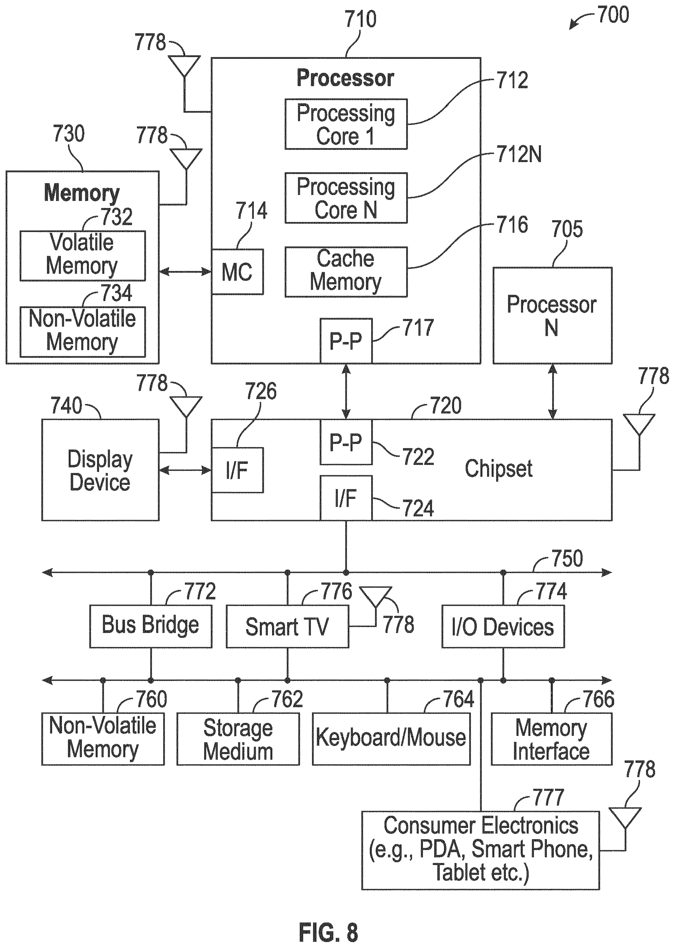

Figure 8 illustrates a system level diagram, depicting an example of an electronic device (e.g., system) that may include an electronic system, for example, from any of the example process flows described above. In one embodiment, system 700 includes, but is not limited to, a desktop computer, a laptop computer, a netbook, a tablet, a notebook computer, a personal digital assistant (PDA), a server, a workstation, a cellular telephone, a mobile computing device, a smart phone, an Internet appliance or any other type of computing device. In some embodiments, system 700 includes a system on a chip (SOC) system.

In one embodiment, processor 710 has one or more processor cores 712 and 712N, where 712N represents the Nth processor core inside processor 710 where N is a positive integer. In one embodiment, system 700 includes multiple processors including 710 and 705, where processor 705 has logic similar or identical to the logic of processor 710. In some embodiments, processing core 712 includes, but is not limited to, pre-fetch logic to fetch instructions, decode logic to decode the instructions, execution logic to execute instructions and the like. In some embodiments, processor 710 has a cache memory 716 to cache instructions and/or data for system 700. Cache memory 716 may be organized into a hierarchal structure including one or more levels of cache memory.

In some embodiments, processor 710 includes a memory controller 714, which is operable to perform functions that enable the processor 710 to access and communicate with memory 730 that includes a volatile memory 732 and/or a non-volatile memory 734. In some embodiments, processor 710 is coupled with memory 730 and chipset 720. Processor 710 may also be coupled to a wireless antenna 778 to communicate with any device configured to transmit and/or receive wireless signals. In one embodiment, an interface for wireless antenna 778 operates in accordance with, but is not limited to, the IEEE 802.11 standard and its related family, Home Plug AV (HPAV), Ultra Wide Band (UWB), Bluetooth, WiMax, or any form of wireless communication protocol.

In some embodiments, volatile memory 732 includes, but is not limited to, Synchronous Dynamic Random Access Memory (SDRAM), Dynamic Random Access Memory (DRAM), RAMBUS Dynamic Random Access Memory (RDRAM), and/or any other type of random access memory device. Non-volatile memory 734 includes, but is not limited to, flash memory, phase change memory (PCM), read-only memory (ROM), electrically erasable programmable read-only memory (EEPROM), or any other type of non-volatile memory device.

Memory 730 stores information and instructions to be executed by processor 610. In one embodiment, memory 730 may also store temporary variables or other intermediate information while processor 710 is executing instructions. In the illustrated embodiment, chipset 720 connects with processor 710 via Point-to-Point (PtP or P-P) interfaces 717 and 722. Chipset 720 enables processor 710 to connect to other elements in system 700. In some embodiments of the example system, interfaces 717 and 722 operate in accordance with a PtP communication protocol such as the Intel^{®} QuickPath Interconnect (QPI) or the like. In other embodiments, a different interconnect may be used.

In some embodiments, chipset 720 is operable to communicate with processor 710, 705N, display device 740, and other devices, including a bus bridge 772, a smart TV 776, I/O devices 774, nonvolatile memory 760, a storage medium (such as one or more mass storage devices) 762, a keyboard/mouse 764, a network interface 766, and various forms of consumer electronics 777 (such as a PDA, smart phone, tablet etc.), etc. In one embodiment, chipset 720 couples with these devices through an interface 724. Chipset 720 may also be coupled to a wireless antenna 778 to communicate with any device configured to transmit and/or receive wireless signals. In one example, any combination of components in a chipset may be separated by a continuous flexible shield as described in the present disclosure.

Chipset 720 connects to display device 740 via interface 726. Display 740 may be, for example, a liquid crystal display (LCD), a light emitting diode (LED) array, an organic light emitting diode (OLED) array, or any other form of visual display device. In some embodiments of the example system, processor 710 and chipset 720 are merged into a single SOC. In addition, chipset 720 connects to one or more buses 750 and 655 that interconnect various system elements, such as I/O devices 674, nonvolatile memory 760, storage medium 762, a keyboard/mouse 764, and network interface 766. Buses 750 and 755 may be interconnected together via a bus bridge 772.

In one embodiment, mass storage device 762 includes, but is not limited to, a solid state drive, a hard disk drive, a universal serial bus flash memory drive, or any other form of computer data storage medium. In one embodiment, network interface 666 is implemented by any type of well-known network interface standard including, but not limited to, an Ethernet interface, a universal serial bus (USB) interface, a Peripheral Component Interconnect (PCI) Express interface, a wireless interface and/or any other suitable type of interface. In one embodiment, the wireless interface operates in accordance with, but is not limited to, the IEEE 802.11 standard and its related family, Home Plug AV (HPAV), Ultra Wide Band (UWB), Bluetooth, WiMax, or any form of wireless communication protocol.

While the modules shown in Figure 8 are depicted as separate blocks within the system 700, the functions performed by some of these blocks may be integrated within a single semiconductor circuit or may be implemented using two or more separate integrated circuits. For example, although cache memory 716 is depicted as a separate block within processor 710, cache memory 716 (or selected aspects of 716) can be incorporated into processor core 712.

### Various Notes and Aspects

Aspect 1 can include a semiconductor substrate comprising a layer having one or more openings, a cavity extending from the one or more openings into the layer, the cavity having side walls and a base, an electrically conductive material positioned proximate to the base of the cavity, the electrically conductive material having a first surface facing the base and an exposed surface opposed to the first surface and the exposed surface faces the one or more opening and an intermediary layer coupled to at least a portion of the exposed surface of the electrically conductive material.

Aspect 2 can include, or can optionally be combined with the subject matter of Aspect 1, to optionally include the first layer is a dielectric layer.

Aspect 3 can include, or can optionally be combined with the subject matter of Aspect 1 or Aspect 2, to optionally include the intermediary layer includes nickel, palladium and gold.

Aspect 4 can include, or can optionally be combined with the subject matter of Aspects 1-3, to optionally include the layer does not include an undercut in the cavity.

Aspect 5 can include, or can optionally be combined with the subject matter of Aspects 1-4, to optionally include the intermediary layer is coupled to at least a portion of the side walls of the cavity.

Aspect 6 can include, or can optionally be combined with the subject matter of Aspects 1-5, to optionally include the electrically conductive material includes copper.

Aspect 7 can include a semiconductor substrate layer comprising a first layer. The first layer including an opening in a first surface or a second opposing surface, one or more cavities, wherein the one or more cavities is recessed a specified distance into the layer. The semiconductor substrate layer comprising an electrically conductive material disposed within the one or more cavities with at first surface facing the opening, a dry deposition layer positioned on at least one of an inner surface of the one or more cavities or with the first surface of the electrically conductive material, and a die coupled to the first layer.

Aspect 8 can include, or can optionally be combined with the subject matter of Aspect 7, to optionally include the first layer is made from glass.

Aspect 9 can include, or can optionally be combined with the subject matter of Aspect 7 or Aspect 8, to optionally include the first layer is made from a polymer.

Aspect 10 can include, or can optionally be combined with the subject matter of Aspects 7-9, to optionally include the electrically conductive material is copper.

Aspect 11 can include, or can optionally be combined with the subject matter of Aspects 7-10, to optionally include the dry deposition layer includes at least one of nickel, palladium and gold.

Aspect 12 can include, or can optionally be combined with the subject matter of Aspects 7-11, to optionally include the dry deposition layer is chemically bonded with an exposed surface of the one or more cavities and the electrically conductive material.

Aspect 13 can include a method of forming a semiconductor substrate layer with an electrically conductive material comprising forming at least one cavity within the substrate layer where a surface of an electrically conductive material is exposed within the at least one cavity. The method including depositing a blocking layer on a first surface of the substrate layer; and applying an intermediary layer to at least the exposed surface of the electrically conductive material.

Aspect 14 can include, or can optionally be combined with the subject matter of Aspect 13, to optionally include introducing the blocking layer concurrently with the intermediary layer.

Aspect 15 can include, or can optionally be combined with the subject matter of Aspect 13 or Aspect 14, to optionally include depositing the blocking layer with physical vapor deposition sequentially with the application of the intermediary layer.

Aspect 16 can include, or can optionally be combined with the subject matter of Aspects 13-15, to optionally include depositing the blocking layer on the first surface and on surfaces within the at least one recess.

Aspect 17 can include, or can optionally be combined with the subject matter of Aspects 13-16, to optionally include the blocking layer is an ammonia-based material.

Aspect 18 can include, or can optionally be combined with the subject matter of Aspects 13-17, to optionally include removing the blocking layer after the dry deposition layer has been applied.

Aspect 19 can include, or can optionally be combined with the subject matter of Aspects 13-18, to optionally include applying the intermediary layer with at least one of chemical vapor deposition or atomic layer deposition.

Aspect 20 can include, or can optionally be combined with the subject matter of Aspects 13-19, to optionally include the substrate layer is formed from at least one of a glass or a polymer.

Each of these non-limiting aspects can stand on its own, or can be combined in various permutations or combinations with one or more of the other aspects.

The above description includes references to the accompanying drawings, which form a part of the detailed description. The drawings show, by way of illustration, specific embodiments in which the invention can be practiced. These embodiments are also referred to herein as "aspects" or "examples." Such aspects or example can include elements in addition to those shown or described. However, the present inventors also contemplate aspects or examples in which only those elements shown or described are provided. Moreover, the present inventors also contemplate aspects or examples using any combination or permutation of those elements shown or described (or one or more features thereof), either with respect to a particular aspects or examples (or one or more features thereof), or with respect to other Aspects (or one or more features thereof) shown or described herein.

In the event of inconsistent usages between this document and any documents so incorporated by reference, the usage in this document controls.

In this document, the terms "a" or "an" are used, as is common in patent documents, to include one or more than one, independent of any other instances or usages of "at least one" or "one or more." In this document, the term "or" is used to refer to a nonexclusive or, such that "A or B" includes "A but not B," "B but not A," and "A and B," unless otherwise indicated. In this document, the terms "including" and "in which" are used as the plain-English equivalents of the respective terms "comprising" and "wherein." Also, in the following claims, the terms "including" and "comprising" are open-ended, that is, a system, device, article, composition, formulation, or process that includes elements in addition to those listed after such a term in a claim are still deemed to fall within the scope of that claim. Moreover, in the following claims, the terms "first," "second," and "third," etc. are used merely as labels, and are not intended to impose numerical requirements on their objects.

Geometric terms, such as "parallel", "perpendicular", "round", or "square", are not intended to require absolute mathematical precision, unless the context indicates otherwise. Instead, such geometric terms allow for variations due to manufacturing or equivalent functions. For example, if an element is described as "round" or "generally round," a component that is not precisely circular (e.g., one that is slightly oblong or is a many-sided polygon) is still encompassed by this description.

The above description is intended to be illustrative, and not restrictive. For example, the above-described aspects or examples (or one or more aspects thereof) may be used in combination with each other. Other embodiments can be used, such as by one of ordinary skill in the art upon reviewing the above description. The Abstract is provided to comply with 37 C.F.R. § 1.72(b), to allow the reader to quickly ascertain the nature of the technical disclosure. It is submitted with the understanding that it will not be used to interpret or limit the scope or meaning of the claims. Also, in the above Detailed Description, various features may be grouped together to streamline the disclosure. This should not be interpreted as intending that an unclaimed disclosed feature is essential to any claim. Rather, inventive subject matter may lie in less than all features of a particular disclosed embodiment. Thus, the following claims are hereby incorporated into the Detailed Description as aspects, examples or embodiments, with each claim standing on its own as a separate embodiment, and it is contemplated that such embodiments can be combined with each other in various combinations or permutations. The scope of the invention should be determined with reference to the appended claims, along with the full scope of equivalents to which such claims are entitled.

## Claims

1. A semiconductor substrate comprising:
a layer having one or more openings;
a cavity extending from the one or more openings into the layer, the cavity having side walls and a base;
an electrically conductive material positioned proximate to the base of the cavity, the electrically conductive material having a first surface facing the base and an exposed surface opposed to the first surface and the exposed surface faces the one or more openings; and
an intermediary layer coupled to at least a portion of the exposed surface of the electrically conductive material.

2. The semiconductor substrate of claim 1, wherein the layer is a dielectric layer.

3. The semiconductor substrate of one of the previous claims, wherein the intermediary layer includes nickel, palladium and gold.

4. The semiconductor substrate of one of the previous claims, wherein the layer does not include an undercut in the cavity.

5. The semiconductor substrate of one of the previous claims, wherein the intermediary layer is coupled to at least a portion of the side walls of the cavity.

6. The semiconductor substrate of one of the previous claims, wherein the electrically conductive material includes copper.

7. A semiconductor substrate layer comprising:
a first layer including:
an opening in a first surface or a second opposing surface;
one or more cavities;
wherein the one or more cavities is recessed a specified distance into the first layer;
an electrically conductive material disposed within the one or more cavities with at first surface facing the opening;
a dry deposition layer positioned on at least one of an inner surface of the one or more cavities or on the first surface of the electrically conductive material; and
a die coupled to the first layer.

8. The semiconductor substrate layer of claim 7, wherein the first layer is made from glass.

9. The semiconductor substrate layer of claim 7, wherein the first layer includes a polymer.

10. The semiconductor substrate layer of one of the claims 7-9, wherein the electrically conductive material is copper.

11. The semiconductor substrate layer of one of the claims 7-10, wherein the dry deposition layer includes at least one of nickel, palladium and gold.

12. The semiconductor substrate layer of one of the claims 7-11, wherein the dry deposition layer is chemically bonded with an exposed surface of the one or more cavities and the electrically conductive material.

13. A method of forming a semiconductor substrate layer with an electrically conductive material comprising:
forming at least one cavity within the semiconductor substrate layer;
wherein a surface of an electrically conductive material is exposed within the at least one cavity;
depositing a blocking layer on a first surface of the semiconductor substrate layer; and
applying an intermediary layer to at least the exposed surface of the electrically conductive material.

14. The method of claim 13, further comprising introducing the blocking layer concurrently with the intermediary layer.

15. The method of claim 13 or 14, further comprising depositing the blocking layer with physical vapor deposition concurrently with application of the intermediary layer.
